# EUROPEAN PATENT SPECIFICATION

(11) **EP 1 952 495 B1**
(45) Date of publication and mention of the grant of the patent: **06.12.2017**
(21) Application number: 06826799.6
(22) Date of filing: 26.10.2006
(51) Int. Cl.: H01S 5/30, H01S 5/32, H01S 5/34

(54) **METHOD AND STRUCTURE OF GERMANIUM LASER ON SILICON**
VERFAHREN UND STRUKTUR VON GERMANIUMLASER AUF SILICIUM
PROCEDE ET STRUCTURE D' UN LASER AU GERMANIUM SUR DU SILICIUM

(30) Priority: 28.10.2005 US 731545 P
(43) Date of publication of application: 06.08.2008
(73) Proprietor: Massachusetts Institute of Technology (MIT), Cambridge, MA 02139 (US)
(72) Inventor: LIU, Jifeng, Cambridge, MA 02139 (US); PAN, Dong, Andover, MA 01810 (US); KIMERLING, Lionel, C., Concord, MA 01742 (US); MICHEL, Jurgen, Arlington, MA 02474 (US); SAINI, Sajan, Cambridge, MA 02139 (US)
(74) Representative: Valea AB
(86) International application number: PCT/US2006/041891
(87) International publication number: WO 2007/053431

(56) References cited:
- US-A- 5 548 128
- US-A- 5 883 912
- US-A1- 2005 082 554

## Description

### PRIORITY INFORMATION

This application claims priority from provisional application Ser. No. 60/731,545 filed October 28, 2005.

### BACKGROUND OF THE INVENTION

The invention relates to the field of Ge lasers, and in particular to a laser structure obtaining efficient light emission at around 1550nm from the direct band gap of Ge.

An efficient laser source on Si is the most crucial device to achieve optoelectronic integrated circuit (OEIC) on Si. Although research on this field has been continued for over two decades, no efficient electrically pumped laser has been demonstrated on Si yet. Therefore, it is of great significance to achieve an efficient, electrically pumped light source on Si platform. Further more, it would be ideal if the light source emits at a wavelength around 1550 nm so that the on-chip optical signals can be easily hooked up with long haul telecommunications.

Germanium is a pseudo-direct band gap material in that the difference between its direct and indirect gap is only 0.136 eV. What is more intriguing is that the direct gap of Ge is 0.8 eV, exactly corresponding to 1550nm. High efficiency Ge photodetectors on Si in this wavelength range have been demonstrated due to the absorption of this direct band gap.

US 2005/082554 discloses a direct-wafer-bonded, double hetero-junction, light emitting semiconductor device which includes an ordered array of quantum dots made of one or more indirect band gap materials selected from a group consisting of Si, Ge, SiGe, SiGeC, 3C-SiC, and hexagonal SiC, wherein the quantum dots are sandwiched between an n-type semiconductor cladding layer selected from a group consisting of SiC, 3C-SiC, 4H-SiC, 6H-SiC and diamond, and a p-type semiconductor cladding layer selected from a group consisting of SiC, 3C-SiC, 4H-SiC, 6H-SiC and diamond. A Ni contact is provided for the n-type cladding layer. An Al, a Ti or an Al/Ti alloy contact is provided for the p-type cladding layer. The quantum dots have a thickness that is no greater than about 250 Angstroms, a width that is no greater than about 200 Angstroms, and a center-to-center spacing that is in the range of from about 10 Angstroms to about 1000 Angstroms.

US 5 548 128 concerns silicon-based laser diodes, optical amplifiers, electro-optical modulators, and photodetectors in which the active region consists of a pseudo-morphic GeSn multiple quantum well stack. Each quantum well is tensile-strained Ge₁₋ₓSnₓ layer sandwiched between compressively strained barriers of Ge_{1-y}Sn_{y} with x -0.1, x<y and y -0.15. The GeSn quantum wells have a strain-induced direct gap for strongly allowed band-to-band transitions in the infrared range. The quantum well stack is grown upon a relaxed SiGeSn alloy buffer portion whose composition is graded up from a lattice match at the silicon substrate interface to a Ge or GeSn composition at buffer's top surface. Doped cladding layers are added, so that the devices have a p-i-n diode structure. The monolithic integrated Column IV devices have a rib waveguide structure, where desired, and operate typically in the 2 to 3 micron wavelength range.

US 5 883 912 describes a vertical cavity surface emitting laser for emitting long wavelength light including a first mirror stack with mirror pairs in a GaAs/AIGaAs material system lattice matched to a GaAs active region with an active structure sandwiched between a first cladding region adjacent the first mirror stack and a second cladding region, the active structure having a quantum well including one of Germanium and Nitrogen, and a second mirror stack lattice matched to the second cladding region and having mirror pairs in a GaAs/AlGaAs material system.

US 2005/082554 discloses a direct-wafer-bonded, double hetero-junction, light emitting semiconductor device which includes an ordered array of quantum dots made of one or more indirect band gap materials selected from a group consisting of Si, Ge, SiGe, SiGeC, 3C-SiC, and hexagonal SiC, wherein the quantum dots are sandwiched between an n-type semiconductor cladding layer selected from a group consisting of SiC, 3C-SiC, 4H-SiC, 6H-SiC and diamond, and a p-type semiconductor cladding layer selected from a group consisting of SiC, 3C-SiC, 4H-SiC, 6H-SiC and diamond. A Ni contact is provided for the n-type cladding layer. An Al, a Ti or an Al/Ti alloy contact is provided for the p-type cladding layer. The quantum dots have a thickness that is no greater than about 250 Angstroms, a width that is no greater than about 200 Angstroms, and a center-to-center spacing that is in the range of from about 10 Angstroms to about 1000 Angstroms.

US 5 548 128 concerns silicon-based laser diodes, optical amplifiers, electro-optical modulators, and photodetectors in which the active region consists of a pseudo-morphic GeSn multiple quantum well stack. Each quantum well is tensile-strained Ge₁₋ₓSnₓ layer sandwiched between compressively strained barriers of Ge_{1-y}Sn_{y} with x ∼0.1, x<y and y ∼0.15. The GeSn quantum wells have a strain-induced direct gap for strongly allowed band-to-band transitions in the infrared range. The quantum well stack is grown upon a relaxed SiGeSn alloy buffer portion whose composition is graded up from a lattice match at the silicon substrate interface to a Ge or GeSn composition at buffer's top surface. Doped cladding layers are added, so that the devices have a p-i-n diode structure. The monolithic integrated Column IV devices have a rib waveguide structure, where desired, and operate typically in the 2 to 3 micron wavelength range.

US 5 883 912 describes a vertical cavity surface emitting laser for emitting long wavelength light including a first mirror stack with mirror pairs in a GaAs/AlGaAs material system lattice matched to a GaAs active region with an active structure sandwiched between a first cladding region adjacent the first mirror stack and a second cladding region, the active structure having a quantum well including one of Germanium and Nitrogen, and a second mirror stack lattice matched to the second cladding region and having mirror pairs in a GaAs/AlGaAs material system.

### SUMMARY OF THE INVENTION

According to one aspect of the invention, there is provided a laser structure according to claim 1. The laser structure includes at least one active layer comprising doped Ge so as to produce light emissions at approximately 1550nm from the direct band gap of Ge. A first confinement structure is positioned on a top region of the at least one active layer. A second confinement structure is positioned on a bottom region of the at least one active layer.

According to one aspect of the invention, there is provided a method of forming a laser structure according to claim 12. The method includes forming at least one active layer comprising doped Ge so as to produce light emissions at approximately 1550nm from the direct band gap of Ge, said doped Ge having an n⁺ doping concentration in the 10¹⁹-10²⁰ /cm³ range. A first confinement structure is positioned on a top region of the at least one active layer, said first confinement structure comprising materials that provide carrier confinement in said at least one active layer; and a second confinement structure being positioned on a bottom region of said at least one active layer and comprising p⁺Si or n⁺Si, said second confinement structure comprising multilayers of two materials with different refractive indexes to form a distributed Bragg reflector. Also, the method includes forming a second confinement structure being positioned on a bottom region of the at least one active layer.

### BRIEF DESCRIPTION OF THE DRAWINGS

FIG. 1 is a graph illustrating the band structure of Ge;
FIG. 2 is a schematic diagram illustrating a lateral emission double hetero-junction (DH) Ge laser on Si;
FIG. 3A is a graph illustrating the calculated light emission intensity vs. injection current (L-I) curve for relaxed and tensile strained Ge material on Si; FIG. 3B is a schematic diagram of a ring laser structure to implement wavelength division multiplexing;
FIG. 4 is a schematic diagram illustrating a quantum well Ge laser on Si;
FIG. 5 is a schematic diagram illustrating a vertical cavity surface emission Ge laser (VCSEL) on Si; and
FIG. 6 is a schematic diagram illustrating another embodiment a vertical cavity surface emission Ge laser (VCSEL) on Si.

### DETAILED DESCRIPTION OF THE INVENTION

The invention provides a technique to obtain efficient light emission at around 1550nm from the direct band gap of Ge.

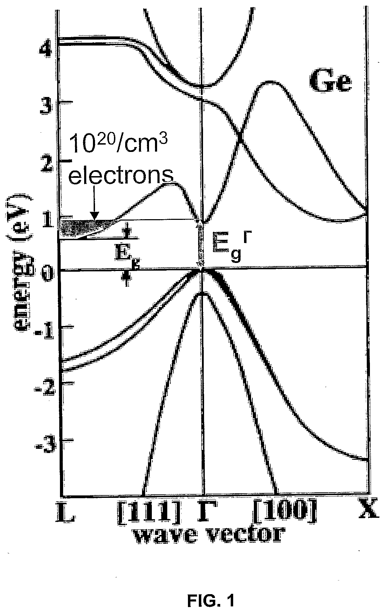

The band structure of Ge is shown in Fig. 1, with the indirect band gap at the L valley and direct gap at Γ valley. To compensate for the 0.136 eV difference between L and Γ valleys, we can fill 1x10²⁰ /cm³ electrons into the conduction band at L valley by heavily n-type doping. Then when carriers are injected into this n⁺ Ge material, electrons will have to populate Γ valley and then recombine with holes via this direct band gap transition, which emits light at 1550nm. In other words, n⁺ Ge with doping concentration greater than 10²⁰ /cm³ is effectively a direct band gap material. This is the basic principle of our Ge laser on Si.

The difference between Γ and L valley can be further decreased by introducing tensile strain into Ge layer by the thermal expansion mismatch between Ge and Si, as has already been demonstrated in tensile strained Ge photodetectors on Si. By introducing 0.25% tensile strain into Ge, the difference between L and Γ valley can be decreased to 0.112 eV, and the n-type doping density needed to start filling Γ valley is reduced to 6.7x10¹⁹ /cm³. With less free carriers in the conduction band the free carrier absorption is reduced, so is the threshold current density for lasing.

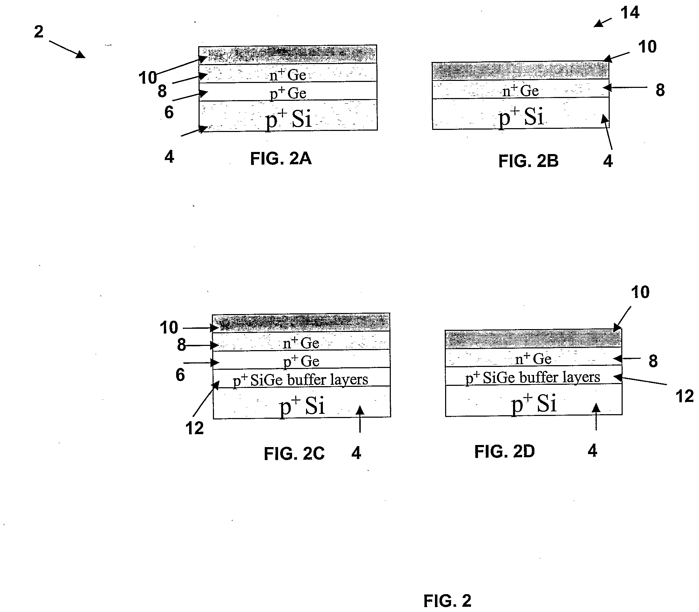

Double hetero-junction (DH) structures of Ge laser diodes 2 on Si are shown in FIGs. 2A-2D. A p⁺ single crystalline Si layer on a Si substrate 4 or SOI substrate is provided, as shown in FIG. 2A. A thin p⁺ Ge layer 6 is grown on the p⁺ Si epitaxially by ultrahigh-vacuum chemical vapor deposition (UHV-CVD), metal-organic chemical vapor deposition (MOCVD), low pressure chemical vapor deposition (LPCVD) or molecular beam epitaxy (MBE). Then an epitaxial n⁺ Ge layer 8 with a doping concentration in the 10¹⁹-10²⁰ /cm³ range is grown on top of this p⁺ Ge layer 6. The doping can be achieved either *in situ* during the Ge growth or by ion implantation. The Ge material can be annealed to decrease the defect density and increase the tensile strain. An n⁺ layer 10 of any semiconductor material that provides electron confinement in Ge layers is grown on top of the n⁺ Ge layer 8. The material for this carrier confinement layer 10 can be, for example, Si (with adequate interface engineering), SiGe alloy with adequate composition (one example is Si_{0.15}Ge_{0.85} nanocrystalline Si, GaAs or AlGaAs.

In FIG. 2A, the Ge layers 8 and 6 act as the active lasing material, while the materials on top 10 and bottom 4 of the n⁺ Ge layer 8 and p⁺ Ge layer 6 provide carrier and photon confinement due to the band offset and lower refractive index compared to Ge. The p⁺ Ge layer 6 is optional in the device structure 2. A structure 14 without the p⁺ Ge layer 6 is shown in FIG. 2B. SiGe buffer layers 12 with heavy p-type doping can be inserted between the p⁺ Si substrate 4 and pure p⁺ Ge layer 6, as shown in FIGs. 2C-2D.

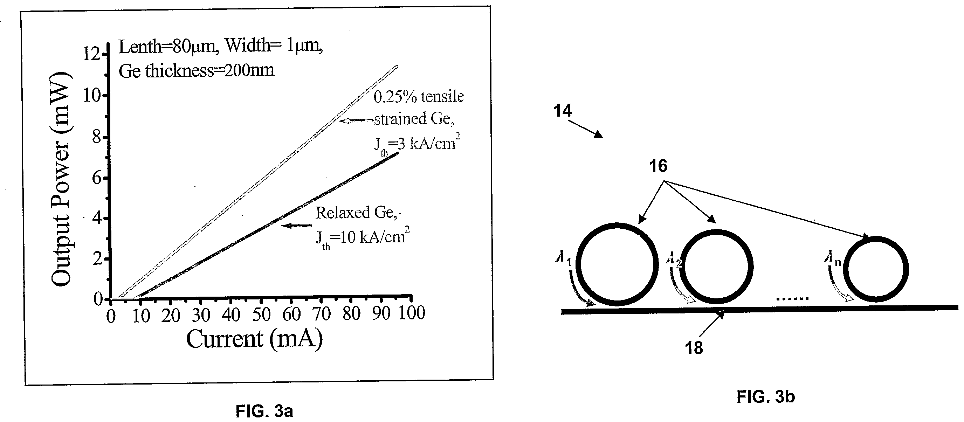

The whole structure forms a lateral emission laser diode, which could be a ridge waveguide, channel waveguide or ring structure. As an example, the calculated light emission intensity vs. injection current (L-I) curve is shown in FIG. 3A. The threshold current of 0.25% tensile strained Ge laser is determined to be 3 kA/cm², and the overall efficiency can reach >10 %, which is comparable to III-V laser devices. FIG 3B shows an example of Ge ring lasers coupled with low loss waveguides 14. With Ge rings 16 of different diameters, multiple emitting wavelengths can be coupled into the same waveguide 18 to achieve wavelength division multiplexing (WDM).

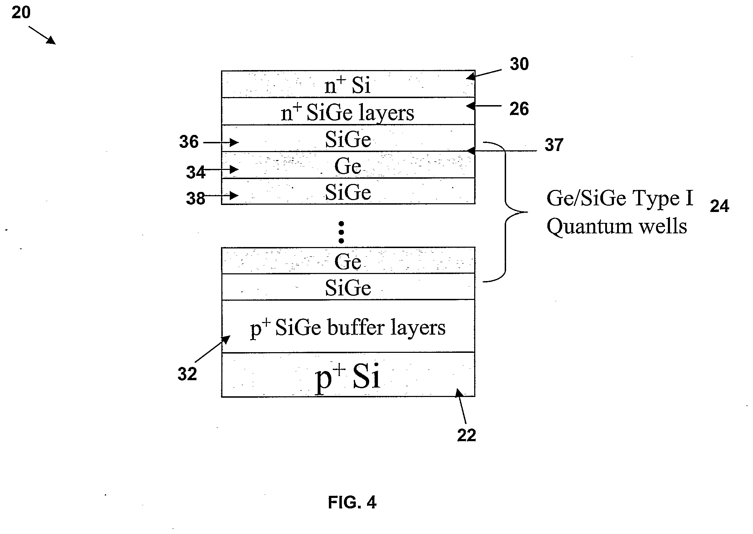

Quantum well (QW) structures of a Ge laser 20 on Si are shown in FIG. 4. This embodiment does not form part of the claimed invention. The laser 20 includes a p⁺ Si substrate 22. A stack of p⁺ SiGe buffer layers 32 is formed on the substrate 22. Quantum wells (QWs) 24 are formed on the buffer layer 32. Note each QW 37 includes a Ge layer 34 that is formed in between SiGe layers 36, 38. A stack of n+ SiGe layers 26 is formed on the quantum wells 24. An n⁺ Si layer 30 is formed on the n+ SiGe layers 26.

In this case, the SiGe thin film layers 36, 38 with adequate composition (for example, Si_{0.15}Ge_{0.85}) provide carrier confinement in the Ge layers 34. These barrier layers can be substituted with any epitaxial semiconductor material that provides carrier confinement in the Ge layers 34, like Si (with adequate interface engineering), GaAs or AlGaAs. As the density of states in Ge QWs is much less than in bulk Ge, the threshold current density for lasing can be further decreased, which is very beneficial for on-chip applications.

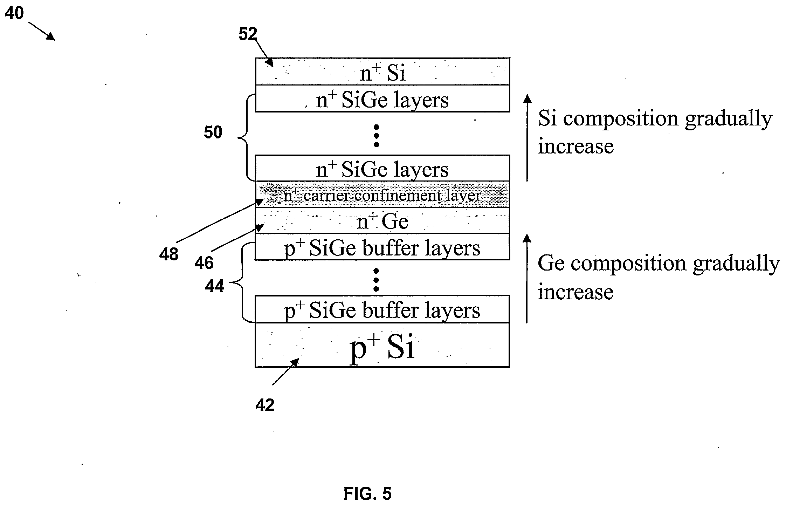

A vertical cavity surface emission laser (VCSEL) 40 can also be achieved by using vertical distributed Bragg reflectors (DBR), as shown in FIG. 5. The laser 40 includes a p⁺ Si substrate 42 where p⁺ SiGe buffer layers 44 are formed. A n⁺ Ge active layer 46 is formed on the buffer layers 44. A n⁺ carrier confinement layer 48 is formed on the active layer 46. A number of n⁺ SiGe layers 50 are formed on the n⁺ carrier confinement layer 48. A n⁺ Si layer 52 is formed on the buffer layers 50.

The SiGe graded buffer layers 44 and 50 have a λ/4 thickness in each layer (λ refers to the wavelength in each layer), which serve as the bottom 44 and top DBR 50. The buffer layer composition is designed such that the top layer 52 and bottom substrate 42 of the device 40 are both Si material so that regular metal contacts in Si CMOS technology can be applied. In this case, the confinement layer 48 can be n⁺ Si, n⁺ SiGe, n+ GaAs or any other semiconductor material that confines electrons in Ge layers. Layer 48 also has a thickness of λ/4. The active Ge layer 46 should be λ/2 in thickness.

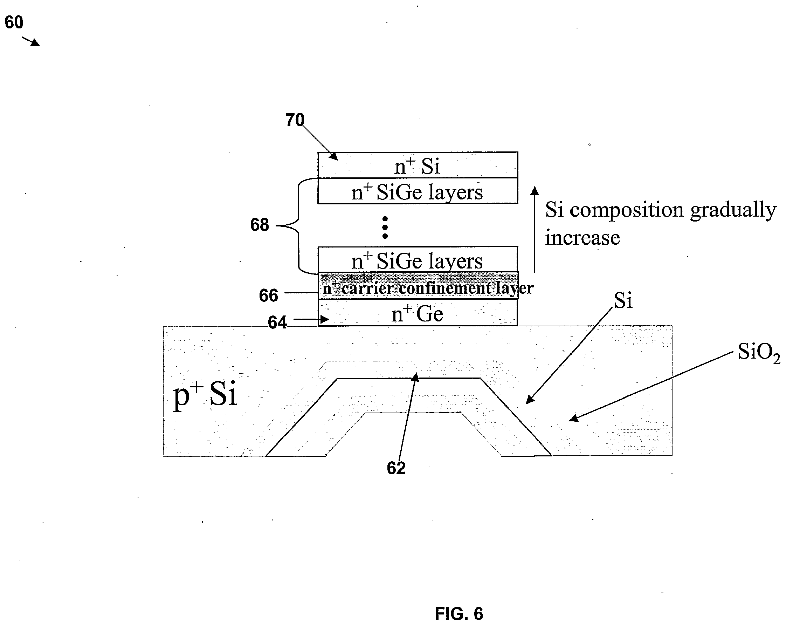

An alternative example of a VCSEL 60 is shown in FIG. 6, where the bottom DBR 62 is consisted of λ/4 SiO₂/Si multi layers deposited on an etched recess on the backside of the wafer. Note the structure includes an active Ge layer 64 that is formed on the bottom DBR 62. A carrier confinement layer 66 is formed on the active Ge layer 64, and it can be Si, SiGe alloy with adequate composition (one example is Si_{0.15}Ge_{0.85}), nanocrystalline Si, GaAs or AlGaAs. Buffer layers 68 are formed on the confinement layer 66, and include n⁺ SiGe layers. An n⁺ Si layer 70 is formed on the buffer layers 68. The materials of the bottom DBR 62 are not restricted to what is described above. It could be any two materials with different refractive index.

Intrinsic, n and p-type Ge, SiGe, GeSn and any other semiconductor material with the direct band gap lower or not too much higher than the indirect band gap can all emit light from the direct gap transitions at high enough carrier injection level, or by loading electrons into the Γ valley directly through some resonant tunneling process. The structure of the active region can also be quantum wells or quantum dots of these materials.

The laser structures described herein can be integrated with other electronic and optoelectronic components in a Si ultralarge-scale integrated circuit (ULSI), and has broad applications in areas like on-chip, chip-to-chip and board-to-board optical interconnection with a bandwidth exceeding 10 GHz, as well as fiber to the home (FTTH) for >10 Gb/s ultra high speed network. This near infrared light source could also be applied to medical applications.

Although the present invention has been shown and described with respect to several preferred embodiments thereof, various changes, omissions and additions to the form and detail thereof, may be made therein, without departing from the scope of the invention as defined by the claims.

## Claims

1. A laser structure (2; 14; 40; 60) comprising:
at least one active layer (6, 8; 46; 64) including doped Ge so as to produce light emissions at approximately 1550nm from the direct band gap of Ge;
a first confinement structure (10; 48; 66) being positioned on a top region of said at least one active layer (6, 8; 46; 64), said first confinement structure (10; 48; 66) comprises materials that provide carrier confinement in said at least one active layer (6, 8; 46; 64); and
a second confinement structure (4, 12; 42, 44; 62) being positioned on a bottom region of said at least one active layer (6, 8; 46; 64), **characterized by**
said doped Ge of said at least one active layer (6, 8; 46; 64) having an n⁺ doping concentration in the 10¹⁹-10²⁰ /cm³ range; and
said second confinement structure (4, 12; 42, 44; 62) comprising p⁺ Si.

2. The laser structure of claim 1, wherein said at least one active layer (6, 8; 46; 64) comprises p+ Ge.

3. The laser structure of claim 1, wherein said materials in said first confinement structure (10; 48; 66) comprise Si, nanocrystalline Si, SiGe, GaAs or AlGaAs.

4. The laser structure of claim 1, wherein said second confinement structure (4, 12; 42, 44; 62) comprises SiO₂/Si multi layers deposited on an etched recess on the backside of a wafer to form a distributed Bragg reflector.

5. The laser structure of claim 4, wherein said second confinement structure (4, 12; 42, 44; 62) comprises multilayers of two materials with different refractive indexes to form a distributed Bragg reflector.

6. The laser structure of claim 1, wherein said first confinement structure (10; 48; 66) comprises buffer layers (50; 68) having n+ SiGe buffer layers.

7. The laser structure of claim 1, wherein said first confinement structure (10; 48; 66) comprises SiGe.

8. The laser structure of claim 1, wherein said second confinement structure (4, 12; 42, 44; 62) comprises SiGe.

9. The laser structure of claim 1, wherein said laser structure (2; 14; 40; 60) comprises a lateral emission device of channel waveguide, ridge waveguide or ring structure.

10. The laser structure of claim 9, wherein said laser structure (2; 14; 40; 60) comprises Ge ring lasers with different radii emitting at different wavelengths and coupled to waveguides for wavelength division multiplexing.

11. The laser structure of claim 1, wherein said laser structure (2; 14; 40; 60) comprises a vertical cavity surface emission structure.

12. The method of forming a laser structure (2; 14; 40; 60) comprising:
forming at least one active layer (6, 8; 46; 64) including doped Ge so as to produce light emissions at approximately 1550nm from the direct band gap of Ge, said doped Ge having an n⁺ doping concentration in the 10¹⁹-10²⁰ /cm³ range;
forming a first confinement structure (10; 48; 66) being positioned on a top region of said at least one active layer (6, 8; 46; 64), said first confinement structure (10; 48; 66) comprises materials that provide carrier confinement in said at least one active layer (6, 8; 46; 64); and
forming second confinement structure (4, 12; 42, 44; 62) being positioned on a bottom region of at least one active layer (6, 8; 46; 64) and comprising p⁺ Si.

13. The method of claim 12, wherein said at least one active layer (6, 8; 46; 64) comprises p+ Ge.

14. The method of claim 12, wherein said materials in said first confinement structure (10; 48; 66) comprise Si, nanocrystalline Si, SiGe, GaAs or AlGaAs.

15. The method of claim 12, wherein said second confinement structure (4, 12; 42, 44; 62) comprises SiO₂/Si multi layers deposited on an etched recess on the backside of a wafer.

16. The method of claim 15, wherein said second confinement structure (4, 12; 42, 44; 62) comprises multilayers of two materials with different refractive indexes to form a distributed Bragg reflector

17. The method of claim 12, wherein said first confinement structure (10; 48; 66) comprises buffer layers (50; 68) having n+ SiGe buffer layers.

18. The method of claim 12, wherein said first confinement structure (10; 48; 66) comprises SiGe.

19. The method of claim 12, wherein said second confinement structure (4, 12; 42, 44; 62) comprises SiGe.

20. The method of claim 12, wherein said laser structure (2; 14; 40; 60) comprises a lateral emission device of channel waveguide, ridge waveguide or ring structure.

21. The method of claim 19, wherein said laser structure (2; 14; 40; 60) comprises Ge ring lasers with different radii emitting at different wavelengths and coupled to waveguides for wavelength division multiplexing.

22. The method of claim 12, wherein said laser structure (2; 14; 40; 60) comprises a vertical cavity surface emission structure.

## Patentansprüche

1. Laserstruktur (2; 14; 40; 60), umfassend:
mindestens eine aktive Schicht (6, 8; 46; 64), die dotiertes Ge aufweist, sodass Lichtemissionen bei ungefähr 1550 nm aus der direkten Ge-Bandlücke erzeugt werden;
eine erste Begrenzungsstruktur (10; 48; 66), die auf einem oberen Bereich der mindestens einen aktiven Schicht (6, 8; 46; 64) liegt, wobei die erste Begrenzungsstruktur (10; 48; 66) Werkstoffe umfasst, die Trägerbegrenzung in der mindestens einen aktiven Schicht (6, 8; 46; 64) versorgen; und
eine zweite Begrenzungsstruktur (4, 12; 42, 44; 62), die auf einem unteren Bereich der mindestens einen aktiven Schicht (6, 8; 46; 64) liegt; **dadurch gekennzeichnet, dass**
das dotierte Ge der mindestens einen aktiven Schicht (6, 8; 46; 64) eine n⁺-Dotierungskonzentration im Bereich von 10¹⁹ bis 10²⁰/cm³ aufweist; und
die zweite Begrenzungsstruktur (4, 12; 42, 44; 62) p⁺-Si umfasst.

2. Laserstruktur nach Anspruch 1, wobei die mindestens eine aktive Schicht (6, 8; 46; 64) ebenso eine p⁺-Ge-Schicht (6) umfasst.

3. Laserstruktur nach Anspruch 1, wobei die Werkstoffe in der ersten Begrenzungsstruktur (10; 48; 66) Si, nanokristallines Si, SiGe, GaAs oder AIGaAs umfassen.

4. Laserstruktur nach Anspruch 1, wobei die zweite Begrenzungsstruktur (4, 12; 42, 44; 62) SiO₂/Si-Multischichten umfasst, die auf eine geätzte Vertiefung auf der Rückseite einer Halbleiterscheibe abgelegt werden, um einen Braggspiegel zu bilden.

5. Laserstruktur nach Anspruch 4, wobei die zweite Begrenzungsstruktur (4, 12; 42, 44; 62) Multischichten aus zwei Werkstoffen mit unterschiedlichen Brechungszahlen umfasst, um einen Braggspiegel zu bilden.

6. Laserstruktur nach Anspruch 1, wobei die erste Begrenzungsstruktur (10; 48; 66) Pufferschichten (50; 68) umfasst, die n⁺-SiGe-Pufferschichten aufweisen.

7. Laserstruktur nach Anspruch 1, wobei die erste Begrenzungsstruktur (10; 48; 66) SiGe umfasst.

8. Laserstruktur nach Anspruch 1, wobei die zweite Begrenzungsstruktur (4, 12; 42, 44; 62) SiGe umfasst.

9. Laserstruktur nach Anspruch 1, wobei die Laserstruktur (2; 14; 40; 60) eine seitliche Emissionsvorrichtung eines Kanalwellenleiters, eines Steghohlleiters oder einer Ringstruktur umfasst.

10. Laserstruktur nach Anspruch 9, wobei die Laserstruktur (2; 14; 40; 60) Ge-Ringlaser mit unterschiedlichen Radien umfasst, die bei unterschiedlichen Wellenlängen emittieren und zum Wellenlängenmultiplexing an Wellenleiter gekoppelt sind.

11. Laserstruktur nach Anspruch 1, wobei die Laserstruktur (2; 14; 40; 60) eine Oberflächenemissionsstruktur umfasst.

12. Verfahren zur Bildung einer Laserstruktur (2; 14; 40; 60), umfassend:
Bilden mindestens einer aktiven Schicht (6, 8; 46; 64), die dotiertes Ge aufweist, sodass Lichtemissionen bei ungefähr 1550 nm aus der direkten Ge-Bandlücke erzeugt werden, wobei das dotiertes Ge eine n⁺-Dotierungskonzentration im Bereich von 10¹⁹ bis 10²⁰/cm³ aufweist;
Bilden einer ersten Begrenzungsstruktur (10; 48; 66), die auf einem oberen Bereich der mindestens einen aktiven Schicht (6, 8; 46; 64) liegt, wobei die erste Begrenzungsstruktur (10; 48; 66) Werkstoffe umfasst, die Trägerbegrenzung in der mindestens einen aktiven Schicht (6, 8; 46; 64) versorgen; und
Bilden einer zweiten Begrenzungsstruktur (4, 12; 42, 44; 62), die auf einem unteren Bereich der mindestens einen aktiven Schicht (6, 8; 46; 64) liegt und p⁺-Si umfasst.

13. Verfahren nach Anspruch 12, wobei die mindestens eine aktive Schicht (6, 8; 46; 64) ebenso eine p⁺-Ge-Schicht (6) umfasst.

14. Verfahren nach Anspruch 12, wobei die Werkstoffe in der ersten Begrenzungsstruktur (10; 48; 66) Si, nanokristallines Si, SiGe, GaAs oder AIGaAs umfassen.

15. Verfahren nach Anspruch 12, wobei die zweite Begrenzungsstruktur (4, 12; 42, 44; 62) SiO₂/Si-Multischichten umfasst, die auf eine geätzte Vertiefung auf der Rückseite einer Halbleiterscheibe abgelegt werden.

16. Verfahren nach Anspruch 15, wobei die zweite Begrenzungsstruktur (4, 12; 42, 44; 62) Multischichten aus zwei Werkstoffen mit unterschiedlichen Brechungszahlen umfasst, um einen Braggspiegel zu bilden.

17. Verfahren nach Anspruch 12, wobei die erste Begrenzungsstruktur (10; 48; 66) Pufferschichten (50; 68) umfasst, die n⁺-SiGe-Pufferschichten aufweisen.

18. Verfahren nach Anspruch 12, wobei die erste Begrenzungsstruktur (10; 48; 66) SiGe umfasst.

19. Verfahren nach Anspruch 12, wobei die zweite Begrenzungsstruktur (4, 12; 42, 44; 62) SiGe umfasst.

20. Verfahren nach Anspruch 12, wobei die Laserstruktur (2; 14; 40; 60) eine seitliche Emissionsvorrichtung eines Kanalwellenleiters, eines Steghohlleiters oder einer Ringstruktur umfasst.

21. Verfahren nach Anspruch 19, wobei die Laserstruktur (2; 14; 40; 60) Ge-Ringlaser mit unterschiedlichen Radien umfasst, die bei unterschiedlichen Wellenlängen emittieren und zum Wellenlängenmultiplexing an Wellenleiter gekoppelt sind.

22. Verfahren nach Anspruch 12, wobei die Laserstruktur (2; 14; 40; 60) eine Oberflächenemissionsstruktur umfasst.

## Revendications

1. Structure de laser (2 ; 14 ; 40 ; 60) comprenant :
au moins une couche active (6, 8; 46; 64) comprenant du Ge dopé afin de produire des émissions lumineuses à approximativement 1550 nm de la bande interdite directe de Ge ;
une première structure de confinement (10 ; 48 ; 66) positionnée sur une région supérieure de ladite au moins une couche active (6, 8 ; 46 ; 64), ladite première structure de confinement (10 ; 48 ; 66) comprend des matériaux qui fournissent un confinement de porteurs dans ladite au moins une couche active (6, 8 ; 46 ; 64) ; et
une seconde structure de confinement (4, 12 ; 42, 44 ; 62) positionnée sur une région inférieure de ladite au moins une couche active (6, 8 ; 46 ; 64), **caractérisée en ce que**
ledit Ge dopé de ladite au moins une couche active (6, 8 ; 46 ; 64) présente une concentration de dopage n⁺ située dans la plage allant de 10¹⁹ à 10²⁰ /cm³ ; et
ladite seconde structure de confinement (4, 12 ; 42, 44 ; 62) comprend du Si p⁺.

2. Structure de laser selon la revendication 1, dans laquelle ladite au moins une couche active (6, 8 ; 46 ; 64) comprend également une couche de Ge p⁺ (6).

3. Structure de laser selon la revendication 1, dans laquelle lesdits matériaux dans ladite première structure de confinement (10 ; 48 ; 66) comprennent du Si, du Si nanocristallin, du SiGe, du GaAs ou de l'AlGaAs.

4. Structure de laser selon la revendication 1, dans laquelle ladite seconde structure de confinement (4, 12 ; 42, 44 ; 62) comprend de multiples couches de SiO₂/Si déposées sur un renfoncement gravé sur la face arrière d'une tranche afin de former un réflecteur de Bragg distribué.

5. Structure de laser selon la revendication 4, dans laquelle ladite seconde structure de confinement (4, 12 ; 42, 44; 62) comprend de multiples couches de deux matériaux avec des indices de réfraction différents pour former un réflecteur de Bragg distribué.

6. Structure de laser selon la revendication 1, dans laquelle ladite première structure de confinement (10 ; 48 ; 66) comprend des couches tampons (50 ; 68) ayant des couches tampons de SiGe n+.

7. Structure de laser selon la revendication 1, dans laquelle ladite première structure de confinement (10 ; 48 ; 66) comprend du SiGe.

8. Structure de laser selon la revendication 1, dans laquelle ladite seconde structure de confinement (4, 12 ; 42, 44 ; 62) comprend du SiGe.

9. Structure de laser selon la revendication 1, dans laquelle ladite structure de laser (2 ; 14 ; 40 ; 60) comprend un dispositif d'émission latérale de guide d'ondes à canal, de guide d'ondes à moulures ou de structure annulaire.

10. Structure de laser selon la revendication 9, dans laquelle ladite structure de laser (2 ; 14 ; 40 ; 60) comprend des lasers annulaires à Ge avec des rayons différents émettant à des longueurs d'onde différentes et couplés à des guides d'ondes pour un multiplexage par répartition en longueur d'onde.

11. Structure de laser selon la revendication 1, dans laquelle ladite structure de laser (2 ; 14 ; 40 ; 60) comprend une structure à émission de surface à cavité verticale.

12. Procédé de formation d'une structure de laser (2 ; 14 ; 40 ; 60) comprenant :
la formation d'au moins une couche active (6, 8 ; 46 ; 64) comprenant du Ge dopé afin de produire des émissions lumineuses à approximativement 1550 nm de la bande interdite directe de Ge, ledit Ge dopé présentant une concentration de dopage n⁺ située dans la plage allant de 10¹⁹ à 10²⁰ /cm³ ;
la formation d'une première structure de confinement (10 ; 48 ; 66) positionnée sur une région supérieure de ladite au moins une couche active (6, 8 ; 46 ; 64), ladite première structure de confinement (10 ; 48 ; 66) comprend des matériaux qui fournissent un confinement de porteurs dans ladite au moins une couche active (6, 8 ; 46 ; 64) ; et
la formation d'une seconde structure de confinement (4, 12 ; 42, 44 ; 62) positionnée sur une région inférieure d'au moins une couche active (6, 8 ; 46 ; 64) et comprenant du Si p⁺.

13. Procédé selon la revendication 12, dans lequel ladite au moins une couche active (6, 8 ; 46 ; 64) comprend également une couche de Ge p⁺ (6).

14. Procédé selon la revendication 12, dans lequel lesdits matériaux dans ladite première structure de confinement (10 ; 48 ; 66) comprennent du Si, du Si nanocristallin, du SiGe, du GaAs ou de l'AlGaAs.

15. Procédé selon la revendication 12, dans lequel ladite seconde structure de confinement (4, 12 ; 42, 44 ; 62) comprend de multiples couches de SiO₂/Si déposées sur un renfoncement gravé sur la face arrière d'une tranche.

16. Procédé selon la revendication 15, dans lequel ladite seconde structure de confinement (4, 12 ; 42, 44; 62) comprend de multiples couches de deux matériaux avec des indices de réfraction différents pour former un réflecteur de Bragg distribué.

17. Procédé selon la revendication 12, dans lequel ladite première structure de confinement (10 ; 48 ; 66) comprend des couches tampons (50 ; 68) ayant des couches tampons de SiGe n+.

18. Procédé selon la revendication 12, dans lequel ladite première structure de confinement (10 ; 48 ; 66) comprend du SiGe.

19. Procédé selon la revendication 12, dans lequel ladite seconde structure de confinement (4, 12 ; 42, 44; 62) comprend du SiGe.

20. Procédé selon la revendication 12, dans lequel ladite structure de laser (2; 14 ; 40; 60) comprend un dispositif d'émission latérale de guide d'ondes à canal, de guide d'ondes à moulures ou de structure annulaire.

21. Procédé selon la revendication 19, dans lequel ladite structure de laser (2; 14; 40 ; 60) comprend des lasers annulaires à Ge avec des rayons différents émettant à des longueurs d'onde différentes et couplés à des guides d'ondes pour un multiplexage par répartition en longueur d'onde.

22. Procédé selon la revendication 12, dans lequel ladite structure de laser (2; 14; 40 ; 60) comprend une structure à émission de surface à cavité verticale.
